# EUROPÄISCHE PATENTSCHRIFT

(11) **EP 3 630 302 B1**
(45) Veröffentlichungstag und Bekanntmachung des Hinweises auf die Patenterteilung: **25.08.2021**
(21) Anmeldenummer: 18734742.2
(22) Anmeldetag: 24.05.2018
(51) Int. Cl.: H05K 7/14, H05K 7/20, A62C 3/16, A62C 99/00, E05G 1/00, H02B 1/56, H02B 1/28

(54) **SICHERHEITSSCHRANK FÜR AKTIVE ELEKTRISCHE UND/ODER ELEKTRONISCHE KOMPONENTEN**
SAFE FOR ACTIVE ELECTRICAL AND/OR ELECTRONIC COMPONENTS
ARMOIRE DE SÉCURITÉ POUR COMPOSANTS ÉLECTRIQUES ET/OU ÉLECTRONIQUES ACTIFS

(30) Priorität: 02.06.2017 DE 102017005287
(43) Veröffentlichungstag der Anmeldung: 08.04.2020
(73) Patentinhaber: Datanet GmbH, 98574 Schmalkalden (DE)
(72) Erfinder: THORWARTH, Peter, 98593 Floh-Seligenthal (DE)
(86) Internationale Anmeldenummer: PCT/DE2018/000159
(87) Internationale Veröffentlichungsnummer: WO 2018/219374

(56) Entgegenhaltungen:
- EP-A1- 2 618 643
- EP-A2- 1 172 127
- WO-A1-2012/036731
- US-A1- 2006 075 509

## Beschreibung

Die Erfindung betrifft einen Sicherheitsschrank für aktive elektrische und/oder elektronische Komponenten welcher für die in diesem angeordneten Komponenten eine höchstmögliche Sicherheit gegenüber äußeren Ereignissen/Einwirkungen, beispielsweise Brandereignissen u.ä. gewährleistet.

Im Stand der Technik sind für Schaltschränke. Feuerlöschsysteme und ähnliches vorbeschrieben.

So offenbart die EP 0 459 944 A1 eine Vorrichtung und ein Verfahren für einen objektgebundenen Brandschutz für eine wenigstens partiell durch ein Gehäuse abgeschlossene elektrische und/oder elektronische Anlage, mit einem Brand-Detektor im Warmluftstrom der zu schützenden Anlage und wenigstens einer Austrittsöffnung eines Löschmittelbehälters innerhalb des Gehäuses der zu schützenden Anlage.

Diese Lösung hat jedoch den Nachteil, dass im Brandfall, auf Grund des bei dieser Lösung eingesetzten Löschprinzips - Notinertisierung durch Löschgaszufuhr (Kohlendioxid), die sauerstoffhaltige Luft im Objekt (z.B. im IT-Schrank) verdrängen muss. Dies geschieht über seitlich am Gehäuse angeordnete Luftaustritte und schlitzartige Entlüftungen an der Oberseite des Gehäuses.

Mit dieser Lösung ist in einem gewissen Umfang zwar Brandsicherheit zu gewährleisten, doch vergeht bei dieser Lösung bis zur Einleitung des Löschvorgangs wertvolle Zeit, in der sich ein Brandschaden ständig vergrößert. Zudem erfordert das Löschgas CO₂ im Handling höhere Sicherheitsvorkehrungen, und auch der stets zwingend innerhalb des Gehäuses befindliche Löschmittelbehälter verhindert eine optimale Ausnutzung des Schutzraumes innerhalb des Gehäuses.

Zudem kann mit der vg. Lösung keine Sicherheit gegenüber "krimineller Energie", d.h. eine Einbruchs- und Sabotagesicherheit gewährleistet werden, da eine derartige Gehäusekonstruktion auf Grund des bei dieser Lösung im Brandfall zwingend erforderlichen Prinzip der Luftverdrängung mit Luftaustritten und Entlüftungen den dabei zu erwartenden Beanspruchungen nicht standhält. Aus der EP 0 966 732 B1 ist ein Schaltschrank für Server u. ä. Einbauten insbesondere Teile empfindlicher Computereinrichtungen bekannt, dessen Innenraum mit Löschgas enthaltende Gasflaschen verbunden ist und der kontinuierlich über einen Ventilator mit Frischluft versorgt wird, wobei in den Abgasstrom außerhalb des Innenraums Brandfrüherkennungssensoren geschaltet sind, die im Brandfall aktiviert werden, wobei in den im Brandfall über die Brandfrüherkennungssensoren aktivierten Gasflaschen das Edelgas Argon enthalten ist.

Auch diese Lösung hat im Brandfall aufgrund ihres Löschprinzips - Not - Inertisierung durch Löschgaszufuhr (Argon) ebenfalls den Nachteil, dass die sauerstoffhaltige Luft im zu schützenden Objekt (z.B. Schaltschrank) zunächst erst mal verdrängen muss.

Dies geschieht bei dieser Lösung dadurch, dass im Brandfall zwei Rauchsensoren über eine Steuerung einen Lüfter, der im Normalfall die Schrankkühlung mit Außenluft realisiert, abschalten und gleichzeitig eine bis dahin offene "Deckwand" verschließen.

Die Steuerung bewirkt durch anschließendes Öffnen eines Magnetventils, dass Löschgas über eine Löschdüse in den Innenraum des zu inertisierenden Schrankes einströmt. Auch bei dieser Lösung wird im Brandfall die sauerstoffhaltige Luft über eine Ansaugdüse aus dem Schrankinnern über ein Versorgungsrohr zur Außenatmosphäre abgeführt.

Auch diese Lösung weist wiederum alle bereits in Verbindung mit der Lösung nach der EP 0 459 944 A1 erläuterten Nachteile des Standes der Technik auf.

Die EP 2 618 643 A1 beschreibt einen Netzwerkschrank mit mindestens einem als kühltechnisch geschlossenem Gefäß ausgebildeten Schrankkörper, wobei über jedem dieser Schrankkörper, ein mit Inertgas gefüllter Feuerlöscher angeordnet ist, welcher nach der Erkennung eines Brandes dann das Löschen des Brandes im Inneren des jeweiligen Schrankkörpers durch eine Inertisierung des Schrankinneren jedoch erst nach der Brandauslösung ermöglicht. Diese in der EP 2 618 643 A1 vorbeschriebene Lösung ermöglicht zwar das Löschen eines bereits ausgebrochenen Brandes, beispielsweise auch im Inneren eines Datenschrankes, kann jedoch weder dessen Entstehung verhindern, noch kann mittels der in der EP 2 618 643 A1 vorbeschriebene Lösung ein Datenschrank wirkungsvoll vor äußeren Brandeinwirkungen, Einbruch oder auch vor Sabotage geschützt werden.

In der DE 10 2006 048 015 A1 wird eine Feuerlöschanlage für ein Gehäuse, vorzugsweise ein Elektronikgehäuse, bestehend aus einem Löschmittelbehälter, welcher das Löschmittel bevorratet, einer Löschmittelabgabeeinrichtung und einer Auslöseeinrichtung, vorbeschrieben. In den Löschmittelbehälter sind alle zur Überwachung, Auslösung und Löschmittelabgabe erforderlichen elektronischen oder/und mechanischen Mittel so integriert, dass dieser kompakt als Löscheinschub eine rechteckige Form von 19" Breite und 44 mm Höhe aufweist. Die in der DE 10 2006 048 015 A1 vorbeschriebene Lösung ermöglicht wiederum lediglich das Löschen eines bereits im Innern eines Gefäßes ausgebrochenen Brandes. Mit der in der DE 10 2006 048 015 A1 vorbeschriebenen Lösung kann weder die Entstehung eines Brandes verhindert, noch kann mittels dieser Lösung das Innere eines Gefäßes wirkungsvoll vor äußeren Brandeinwirkungen, Einbruch oder Sabotage geschützt werden, da auch diese Lösung zwingend einen Überdruck-Auslass (eine Expansionsklappe) erfordert, der ein Bersten des zu löschenden Gefäßes beim Einströmung des Löschgases verhindert.

Zudem ist aus der GB 2 420 279 A ein beweglicher Datenschrank mir integrierter, im Brandfall auslösender Feuerlöscheinrichtung bekannt, welcher eine 25 mm starke Kalziumsilikatisolierung aufweist, die jedoch nur geringen Anforderungen vor äußeren Brandeinwirkungen gerecht wird, und die daher nur einen beschränktem äußeren Brandwiderstand gewährleisten kann. Zur Erhöhung der Mobilität, z.B. bei Umzügen, ist der Schrank auf Rollen gelagert, wodurch jedoch auch ein Komplettdiebstahl deutlich erleichtert wird. Auch diese Lösung ermöglicht wiederum lediglich das Löschen eines bereits ausgebrochenen Brandes, so dass auch mittels dieser Lösung weder die Entstehung eines Brandes verhindert, noch das zu schützende Objekt wirkungsvoll vor äußeren Brandeinwirkungen, Einbruch, Sprengung, oder auch Sabotagen aller Art geschützt werden kann.

Die DE 10 2009 013 495 A1 beschreibt ein Brandlöschsystem mit Inertgas für geschlossene Lagerbehältersysteme, welches wiederum erst nach einer Branderkennung durch Sauerstoffverdrängung mittels Inertisierung des zu schützenden Objektes, den Brand löscht. Eine wesentliche Besonderheit dieser Lösung besteht darin, dass, um den Brand zu löschen, zunächst nur partiell, also nur an Stellen wo der Brand zuerst detektiert wurde, durch Zuströmen von Inertgas, eine Inertisierung der Umgebungsluftvolumina auf einen Sauerstoffgehalt von weniger als 13 Prozent bewirkt wird. Das System funktioniert ähnlich wie eine Sprinkleranlage, nur das hier statt Wasser Inertgas (z.B. Stickstoff) verwendet wird. Die Auslösung erfolgt im Regelfall temperaturabhängig durch Berst-Röhrchen (Bulbs), kann aber auch durch Rauchdetektoren und ggf. anzusteuernde Magnetventile erfolgen. Auch diese Lösung ermöglicht wiederum lediglich das Löschen eines bereits ausgebrochenen Brandes, so dass auch mittels dieser Lösung weder die Entstehung eines Brandes verhindert, noch das zu schützende Objekt wirkungsvoll vor äußeren Brandeinwirkungen, Einbruch, Sprengung oder auch Sabotagen aller Art geschützt werden kann.

Weiterhin ist aus der DE 100 33 650 A1 eine Anlage und ein Verfahren zum Lagern und/oder Verarbeiten von Gegenständen unter inerten Bedingungen (Dauerinertisierung) bekannt. Die dort beschriebene Anordnung ermöglicht eine Ein- und Auslagerung von Gegenständen in einen dauerinertisierten Raum, dem eine Ein-/Ausgabeschleuse vorgeschaltet ist, in der die zu lagernden oder zu verarbeitenden Gegenstände eingebracht werden und in der mittels des Verfahrens mit einer entsprechenden Steuerung durch Spülen und Verdrängen die Inertgas-Verluste soweit wie möglich minimiert werden. Diese Lösung ist jedoch für den Einsatz in einem Sicherheitsschrank für aktive elektrische und elektronische Komponenten nicht geeignet und auch zu kostenintensiv, da während des Öffnens des Sicherheitsschrankes die Inertgas-Atmosphäre nicht aufrecht erhalten werden muss. Zudem kann mittels dieser Lösung keinesfalls eine durch einen Sicherheitsschrank für elektrische und elektronische Komponenten zu realisierende Feuer-, Einbruchs- und Sabotagesicherheit gewährleistet werden. Aus der DE 27 44 767 A1 ist darüberhinaus ein Verfahren zur Inertisierung von geschlossenen Behältern (z.B. Brauereikesseln) bekannt. Bei dieser Lösung wird das Inertgas Stickstoff "Vor-Ort" nach einem Kreislaufprinzip erzeugt. Diese Lösung ist aus Kostengründen wegen des hohen apparatetechnischen Aufwandes für einen Sicherheitsschrank für elektrische und elektronische Komponenten nicht anwendbar. Zudem kann auch mit dieser Lösung keinesfalls die mittels eines Sicherheitsschrankes für elektrische und elektronische Komponenten zu realisierende Feuer-, Einbruch- und Sabotagesicherheit gewährleistet werden

Weiterhin ist aus der EP 0 642 456 B1 eine Vorrichtung zur Erzeugung einer inerten Atmosphäre innerhalb eines Lagertanks bekannt, bei der unter Anwendung pneumatisch verknüpfter Steuer- und Regelventile eine Befüllung und eine automatische Überdruckhaltung, zur Kompensation von Leckverlusten, bewirkt wird. Auch diese Lösung ist für den Einsatz in/an einem Sicherheitsschrank für aktive elektrische und elektronische Komponenten nicht geeignet, da sie einerseits zu kostenintensiv ist und zudem die in diesem Zusammenhang erforderliche Feuer-, Einbruchs- und Sabotagesicherheit bei "kriminellen Zugriff Dritter" keinesfalls gewährleisten kann.

Aus der US 2006 / 0 075 509 A1 ist auch eine brandgeschützte Festplattenspeicher-Einheit auf Basis von zwei "gespiegelten" Festplatten bekannt, bei der die beiden Festplatten mit einem externen Host kommunizieren können. Eine der beiden Festplatten ist hermetisch verschlossen (versiegelt) und dadurch gegen Staubbelastung und Druckschwankungen der Außenluft, stehendes Wasser, Strahlung, Stöße usw. geschützt. Die Wärmeabfuhr wird durch außen am Festplattengehäuse angebrachte Kühlrippen und mittels einer Zwangskühlung durch Lüfter, die Strom- und Datenversorgung wird mittels einer besonderen Leiterplatine ohne Wärmebrücken zum Festplatteninneren gewährleistet. Diese hermetisch gekapselte Festplatte ist zudem in ein hitzeisolierendes Gehäuse aus phasenveränderlichem Spezialdämmstoff eingebaut, welches durch eine ebenfalls hitzeisolierende Klappe im Brandfall mittels eines Federmechanismuses verschlossen wird. Der Brandfall wird bei dieser Lösung durch ein Schmelzlot detektiert. In der auf diese Art geschützten Festplatte sind die Daten im Brand- und Überschwemmungsfall, im Fall eines Aufpralls oder im Fall anderer schädigender Zustände (mit geringer krimineller Energie) relativ sicher. In der US 2006 / 0 075 509 A1 werden jedoch keine Angaben darüber gemacht, über welchen Zeitraum, bei welcher Brandtemperatur und ggf. bis zu welchem Wasserdruck, d.h. welche Schutzwirkung wirklich gewährleistet werden kann.

Die zweite Festplatte ist nicht besonders geschützt, dafür aber leicht zugänglich und erfüllt für den normalen Betriebsfall eine Back-Up-Funktion. Ein wesentlicher Nachteil dieser Lösung nach der US 2006 / 0 075 509 A1 besteht darin, dass nur eine oder mehrere Festplatten auf diese Weise geschützt werden können. Der Schutz kompletter aktiver Storage-Systeme, Server, Switche und/oder sonstiger wichtiger Steuerungen ist mit der in der US 2006 / 0 075 509 A1 vorgeschlagenen Lösung nicht möglich.

Zudem sind im Stand der Technik Daten-Tresore bekannt, in denen Speichermedien wie CD's, Festplatten, u.ä. sabotage- und einbruchssicher, auch bis zu 1200 °C feuersicher gelagert werden können.

In diesen Daten-Tresoren können jedoch keine aktiven elektrischen und elektronischen Komponenten eingebaut werden, da der Energieeintrag für den Betrieb der eingebauten aktiven Komponenten, wie IT-Komponenten, stets die potentielle Gefahr einer Brandentstehung im Inneren des zwingend verschlossenen IT-Tresores herauf beschwört, d.h. die Abwärme der aktiven Komponenten, oder auch mögliche Brandereignisse führen zur Zerstörung dieser aktiven Komponenten.

Aufgrund der technischen Entwicklung und den damit rasant wachsenden Datenmengen wie auch der sich schnell ändernder Inhalte, ist jedoch eine statische Datensicherung, in denen nur das Speichermedium passiv in einem Tresor gesichert wird in vielen Fällen bereits heute nicht mehr ausreichend, es besteht der Bedarf, dass die gesamte aktive IT-Komponente geschützt werden sollte.

Aufgabe der Erfindung ist es daher, einen Sicherheitsschrank für aktive elektrische und elektronische Komponenten zu entwickeln der die beschriebenen Nachteile beseitigt, einen instandhaltungsarmen und zuverlässigen Dauerbetrieb bei sehr hoher Einbruchs- und Sabotagesicherheit und einen sehr hohen Brandschutz gewährleistet und der im Extremfall, d.h. selbst nach dem Kappen aller Verbindungsleitungen zur "Außenwelt", selbst unter einer Brandlast von 1200 °C über 2 Stunden die Sicherheit und Unversehrtheit aller auf den, im Schrankinnenraum angeordneten, o.g. aktiven Komponenten gespeicherten Daten gewährleistet.

Erfindungsgemäß wird diese Aufgabe durch einen Sicherheitsschrank in der Bauform eines Aktivtresors (23) für aktive elektrische und elektronische Komponenten, nachfolgend IT-Komponenten genannt, nach den Merkmalen des Hauptanspruches der Erfindung gelöst. Der erfindungsgemäße Sicherheitsschrank in der Bauform eines Aktivtresors (23) für aktive elektrische und/oder elektronische Komponenten benötigt zum Betrieb dieser aktiven elektrischen/elektronischen Komponenten, nachfolgend IT-Komponenten genannt, im Unterschied zu passiven Datentresoren Energie die dann zwingend auch mit Abwärme verbunden ist.

Die erfindungsgemäße Lösung bietet im Gegensatz zu den im Stand der Technik vorbeschriebenen aktiven Schutzsystemen, die erst nachdem die Sensoren einen Brand erkannt und gemeldet haben, reagieren und daraufhin dann Maßnahmen zur Löschung einleiten, einen passiven Schutz, das bedeutet konkret, dass vor dem Eintritt eines Schadensereignisses bereits alles Erforderliche zur Schadensbegrenzung eingeleitet ist. Dadurch kann sich ein Schaden von der Erkennung eines "Brandes" bis zu dessen Löschung auch nicht ausbreiten, da der zum Brennen erforderliche Sauerstoff fehlt und daher das Brandereignis selbst gar nicht statt findet.

Die erfindungsgemäße Lösung gewährleistet zudem eine sehr hohe Sabotagesicherheit, da im Brand-, Einbruchs- und/oder Sabotagefall von außen keinerlei Handlungen am Aktivtresor (23) vorgenommen werden können welche die erfindungsgemäßen Schutzwirkungen beeinträchtigen könnten.

Von der erfindungsgemäßen Anordnung wird dieser passive Schutz sowohl im Normalbetrieb im Schrankinnern wie aber auch gegenüber äußeren Einwirkungen gewährleistet.

Der passive Schutz des Schrankinnern im Normalbetrieb ist zwingend erforderlich, da der stetige Energieeintrag zum Betrieb der eingebauten aktiven elektrischen und/oder elektronischen Komponenten auch eine potentielle Gefahr einer Brandentstehung im Inneren des Aktivtresors zur Folge hat.

Um dieser potentiellen Gefahr zu begegnen sind neben dem erfindungsgemäß im verschlossenen Tresorinnenraum integrierten Kühlsystem, eine im Tresorinnenraum vorhandenen Inertgasatmosphäre, eine im Tresorinnenraum angeordnete Brandüberwachung (für Schwelbrände ohne Luftsauerstoff), eine Notstromversorgung für ein geordnetes Herunterfahren der zu schützenden aktiven IT-Komponenten und ein in das Kühlsystem integrierter, während der Phase des Herunterfahrens die Aufrechterhaltung einer Notkühlung gewährleistender Kältespeicher angeordnet.

Der passive Schutz gegenüber äußeren Einwirkungen, wie beispielsweise Einbruch, Sabotage, Sprengung oder Gebäudebrand ist dadurch gekennzeichnet, dass bei Eintritt eines solchen Schadensereignisses, selbst wenn alle Versorgungssysteme von der Außenwelt zum Tresorinnern, die Verkabelung, d.h. die Kabel für Strom, die Kabel der Netzwerkverbindungen, wie auch die Versorgungsleitungen des Kühlsystems, aber auch die der Löschgasversorgung durchtrennt wurden, im Innern des Aktivtresors die IT-Komponenten mittels einer integrierten Notstromversorgung in einen Ruhemodus herunter gefahren werden, um so die äußeren Einwirkungen schadlos zu überstehen. Dabei werden mittels eines im Tresorinnern angeordneten, im Notfall hermetisch von der Außenumgebung abtrennbaren Kühlsystems mit einer integrierten Notkühlreserve (z.B. einem Latentkältespeicher), die zu schützenden aktiven IT-Komponente, wie beispielsweise ein Server, während der Abschaltphase, kontinuierlich mittels der Notkühlung/Notkühlreserve gekühlt, um so eine hohe Sicherheit des erfindungsgemäßen Systems bei "Schadenseinwirkung" von Außen, wie beispielsweise im Brand- oder Sabotagefall, zu gewährleistet.

Durch die zum Schutz der aktiven IT-Komponenten im erfindungsgemäßen Sicherheitsschrank integrierten aktiven "Überlebenseinrichtungen", für die zu schützenden aktiven IT-Komponenten, wird dieser zu einem Aktivtresor (23).

Vorteilhafte Ausführungen, Einzelheiten und Merkmale der Erfindung ergeben sich auch aus den Unteransprüchen sowie aus der nachfolgenden Beschreibung der erfindungsgemäßen Ausführungsbeispiele in Verbindung mit drei zeichnerischen Darstellungen der erfindungsgemäßen Lösung.

Nachfolgend soll nun die Erfindung an Hand eines Ausführungsbeispieles in Verbindung mit drei Figuren näher erläutert werden.

Es zeigen dabei:
- Figur 1 :: Sicherheitsschrank für aktive elektrische und/oder elektronische Komponenten mit den diesem zugeordneten Baugruppen in der Vorderansicht ohne die Tresortür (22);
- Figur 2 :: Sicherheitsschrank für aktive elektrische und/oder elektronische Komponenten mit den zugehörigen Baugruppen in der Rückansicht;
- Figur 3 :: Sicherheitsschrank für aktive elektrische und/oder elektronische Komponenten mit den zugehörigen Baugruppen in der Draufsicht, in einer schematischen Schnittdarstellung mit den in der Inertisierungseinheit (10) angeordneten Baugruppen, als Schaltungsanordnung.

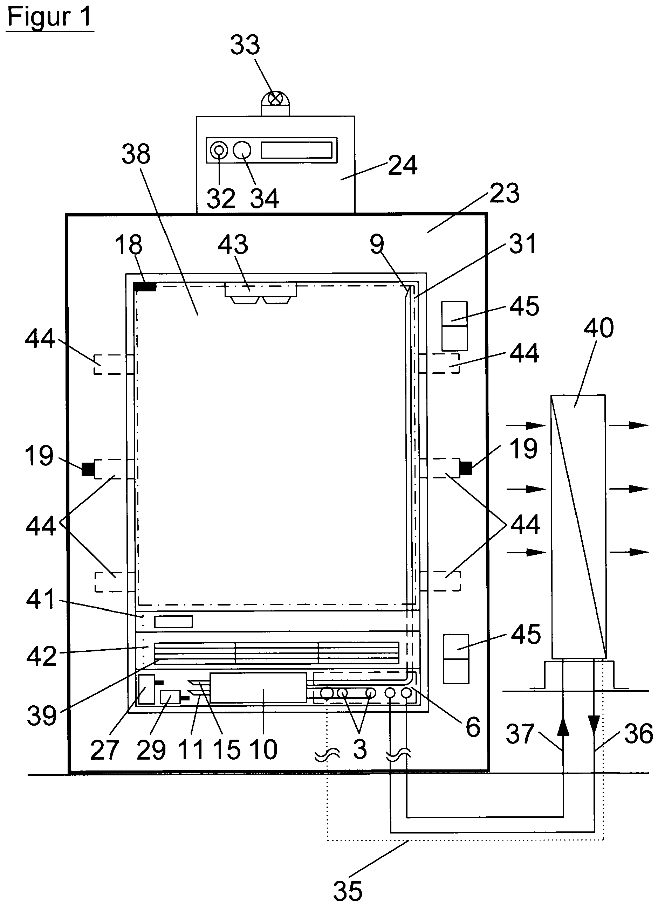

Die Figur 1 zeigt den erfindungsgemäßen Sicherheitsschrank für aktive elektrische und/oder elektronische Komponenten mit den diesem zugeordneten Baugruppen in der Vorderansicht ohne die am Tresortürscharnier 45 anzuordnende Tresortür 22, wobei der größte Volumenanteil des Tresorinneren zum Einbau der zu schützenden aktiven elektrischen und/oder elektronischen Komponenten, wie z.B.für IT-Komponenten, zur Verfügung steht.

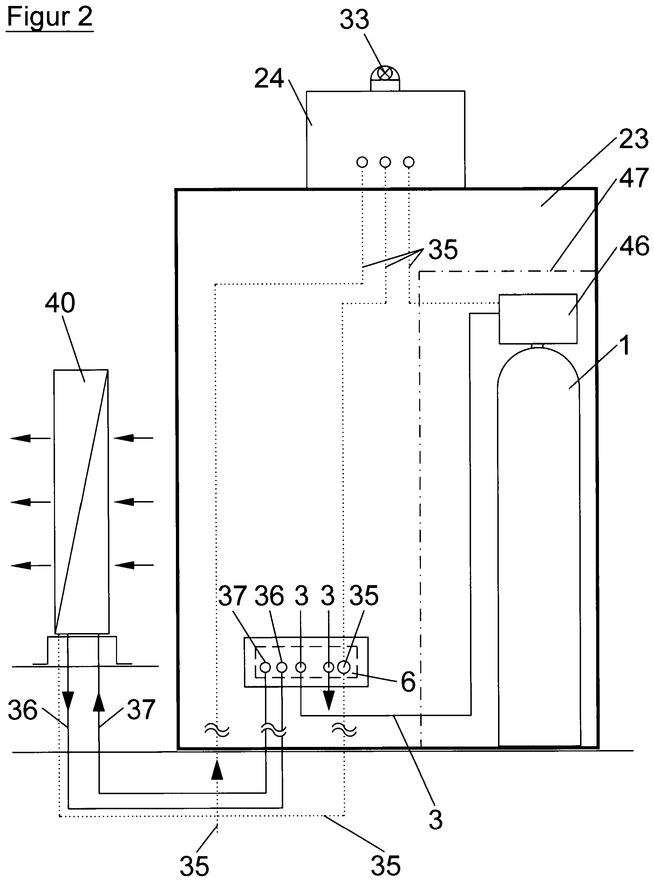

In der Figur 2 ist der Sicherheitsschrank für aktive elektrische und/oder elektronische Komponenten mit den zugehörigen Baugruppen in der Rückansicht schematisch dargestellt.

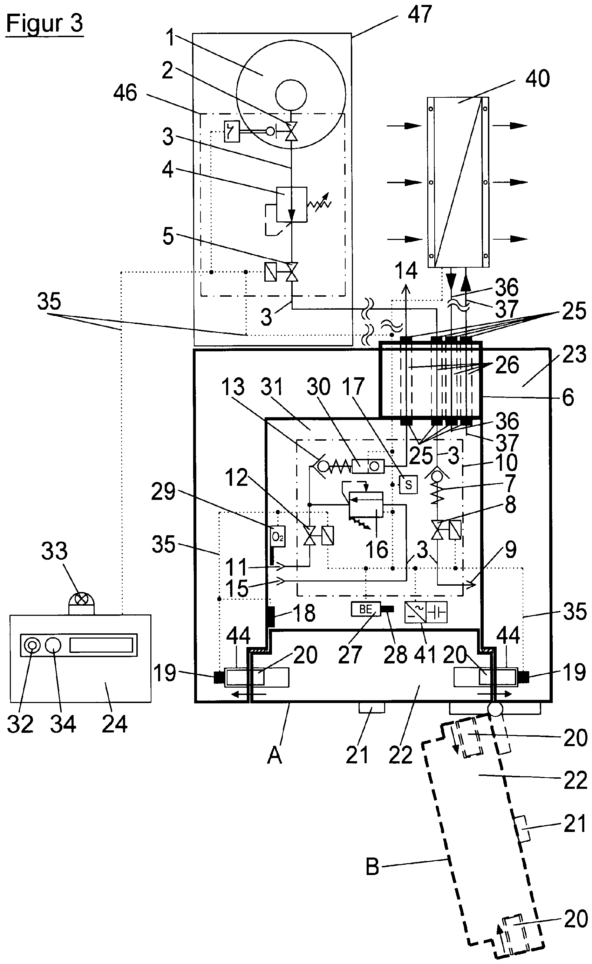

In diesem, in den Figuren 1 und 2 dargestellten Sicherheitsschrank, in der Bauform eines Aktivtresors 23, mit einer luftdicht, den Aktivtresor 23 mittels einer Öffnungs- und Schießvorrichtung, der Verschlussvorrichtung 21, verschließenden (in der Figur 3 dargestellten) Tresortür 22 sind hauptsächlich aktive elektrische und/oder elektronische Komponenten, wie IT-Komponenten 38 angeordnet. Die an den IT-Komponenten 38 angeordneten Verkabelungen 35 werden durch in der Tresorwand angeordnete, luftdichte Brandschottungen 6 hindurch aus dem Tresorinneren nach außen geführt. Die luftdichten Brandschottungen 6 gewährleisten eine hohe Feuer- und Einbruchssicherheit.

Erfindungswesentlich ist auch, dass im Tresorinneren des Aktivtresors 23 ein Wärmetauscher 39 angeordnet ist, der mit einer in den Figuren 1 und 2 dargestellten, außerhalb des Aktivtresors 23 angeordneten, Kältemaschine 40 über die Rohrleitungen, eines Kältemittelvorlaufs 36 und eines Kältemittelrücklaufs 37 verbunden ist, um mittels dieser Kühlung einen zuverlässiger Normalbetrieb der aktiven elektrischen und/oder elektronischen Komponenten, wie z.B. der IT-Komponenten 38, zu gewährleisten.

Auch diese Rohreitungen sind durch in der Tresorwand angeordnete, luftdichte Brandschottungen 6 hindurch aus dem Tresorinneren nach außen geführt und gewährleisten im Bedarfsfall, d.h. bei einem Brandereignis eine hohe Sicherheit indem sich die Brandschottungen 6 unter Hitzeeinwirkung hermetisch verschließen.

In den, im Tresorinneren des erfindungsgemäßen Sicherheitsschrankes, des Aktivtresors 23, angeordneten Wärmetauscher 39 ist ein Latentkältespeicher 42 integriert, der gewährleistet, dass im Notfall, d.h. bei Kappen aller Außenleitungen, stets ein systematisches Herunterkühlen der IT-Komponenten 38, ohne kurzzeitige Überhitzung der aktiven elektrischen und/oder elektronischen Komponenten, wie z.B. der IT-Komponenten 38, gewährleistet ist.

Die notwendige Energie zum Betrieb einer Notkühlung, oder zum Herunterfahren der Rechner liefert die im Tresorinneren des erfindungsgemäßen Sicherheitsschrankes, des Aktivtresors 23, angeordnete Notstromversorgung 41.

Im Innenraum 31 des erfindungsgemäßen Sicherheitsschrankes, des Aktivtresors 23, ist zudem Brandfrühsterkennungssensor 43 angeordnet, um auch Schwelbrände, für die kein Luftsauerstoff benötigt wird, rechtzeitig zu erkennen.

Im Tresorinneren des Aktivtresors 23 befindet sich eine Inertisierungseinheit 10 an der Löschgasleitungen 3 angeordnet sind, die durch in der Tresorwand angeordnete, luftdichte Brandschottungen 6 hindurch aus dem Tresorinneren nach außen geführt sind, um im äußeren Brandfall den Innenraum 31 des Aktivtresors 23 mit den dort angeordneten IT-Komponenten 38 zuverlässig zu schützen, um auch im äußeren Brandfall eine hohe Sicherheit für die zu schützenden IT-Komponenten 38 zu gewährleisten.

Die Figur 3 zeigt den erfindungsgemäßen Sicherheitsschrank für aktive elektrische und/oder elektronische Komponenten, hier für IT-Komponenten 38, den Aktivtresor 23, mit den zugehörigen Baugruppen in der Draufsicht, in einer schematischen Schnittdarstellung mit den in der Inertisierungseinheit 10 angeordneten Baugruppen, als Schaltungsanordnung.

Eine der Löschgasleitungen 3 dient in der Inertisierungsphase des Innenraumes 31 des Aktivtresors 23 der Löschgaszuleitung und die andere der Löschgasleitungen 3 dient in der Inertisierungsphase der Ableitung der aus dem erfindungsgemäßen Sicherheitsschrank, dem Aktivtresor 23, beim Inertisieren verdrängten Luft (bzw. des Löschgasluftgemisches) aus dem Innenraum 31 in die Außenatmosphäre 14.

An der Inertisierungseinheit 10 ist ein in den Innenraum 31 des Aktivtresors 23 mündender Löschgaseinlass 9, und diesem Löschgaseinlass 9 ist an der Inertisierungseinheit 10 gegenüberliegend, ein den Austritt der noch sauerstoffhaltigen Gase aus dem luftdicht verschlossenen Tresorinneren ermöglichender Luftauslass 11 angeordnet.

Die noch sauerstoffhaltigen Gase passieren das während der Inertisierungsphase durch die Steuerung 24 geöffnete Gasauslassmagnetventil 12, das Rückschlagventil 13, den Strömungswächter 30 und gelangen dann in die Außenatmosphäre 14.

Der benachbart zum Luftauslass 11 angeordnete Überdruckauslass 15 hat die Aufgabe, im Falle eines Steuerungs- oder Bauteilversagens den Aufbau eines unzulässigen Überdruckes im Tresorinneren zu verhindern.

In einem solchen Fall strömt das Gas durch den Überdruckauslass 15 durch das infolge Überdruck selbsttätig geöffnete Überdruckventil 16, das Rückschlagventil 13 und den Strömungswächter 30 in die Außenatmosphäre 14.

Im Bereich des Luftauslasses 11 ist im Tresorinneren ein Sauerstoffsensor 29 angeordnet, der den Grad der Inertisierung misst und diesen der Steuerung 24 meldet, so dass diese nach dem Erreichen des gewünschten Inertisierungsgrades die Löschgaszufuhr in das Tresorinnere stoppt.

Im Innern des Aktivtresors 23 ist zudem ein Luftfeuchtesensor 28 mit einer von diesem gesteuerten Befeuchtungseinrichtung 27 zur Vermeidung von statischer Elektrizität angeordnet.

Da elektronische Einrichtungen zur Vermeidung von statischer Elektrizität mit einer relativen Luftfeuchte zwischen 50 und 60% betrieben werden sollten, und Inertgase in der Regel eine sehr geringe Restfeuchte von unter 10% besitzen, wird diese durch den Luftfeuchtesensor 28 erfasst und der Steuerung 24 gemeldet. Diese steuert die Befeuchtungseinrichtung 27 so lange an, bis beispielsweise nach einer Neubefüllung mit Löschgas die geforderte Luftfeuchte, wieder erreicht ist, so dass mittels der erfindungsgemäßen Anordnung auch unter inerten Bedingungen optimaler Luftfeuchte zur Vermeidung von statischer Elektrizität gewährleistet werden kann.

Die in der Inertisierungseinheit 10 angeordneten Bauteile sind über Verkabelungen 35 mit einer außerhalb des Aktivtresors 23 angeordneten Steuerung 24, einem ebenfalls außerhalb des Aktivtresors 23 angeordneten Löschgasspeicher 1, und/oder mit in dessen Löschgasleitung 3 angeordneten Baugruppen einer Gasspeichersteuerung 46 verbunden, wobei auch diese Verkabelungen 35 durch in der Tresorwand angeordnete, luftdichte Brandschottungen 6 hindurch aus dem Tresorinneren nach außen zu den jeweiligen Baugruppen geführt sind. Die Inertisierungseinheit 10 bewirkt im Zusammenwirken mit der Steuerung 24, dem Löschgasspeicher 1 und dessen Gasspeichersteuerung 46 eine automatische, feuer-, einbruch- und sabotagesichere bauraumoptimierte Dauerinertisierung des Aktivtresors 23. Der Gasspeicher 1 und die Gasspeichersteuerung 46 sind gemeinsam in einem Gasspeicherschutzgehäuse 47 extern angeordnet.

Durch die externe Anordnung von Baugruppen wird gewährleistet, dass der (sehr teure) Raum im Inneren des Aktivtresors nicht für Baugruppen, wie die Steuerung 24, den Löschgasspeicher 1 und dessen Gasspeichersteuerung 46 benötigt wird, so dass ein möglichst großer Innenraum 31 im Tresorinneren des Aktivtresors 23 zur Anordnung von IT-Komponenten 38 zur Verfügung steht.

Bei Anordnung von mehreren Aktivtresoren kann die Steuerung 24 selbstverständlich auch mehrere Aktivtresore 23 verwalten, wie ebenso mit einem Gasspeicher 1 auch mehrere Aktivtresore 23 inertisiert werden können. Selbstverständlich können auch die Wärmetauscher 39 mehrerer Aktivtresore 23 mit nur einer Kältemaschine 40 betrieben werden. In der Regel sind zudem der Löschgasspeicher 1 und auch die Kältemaschine 40 nicht zwingend,. wie in den Figuren 1 bis 3 aus zeichnerischen Gründen dargestellt, unmittelbar im Tresorbereich, d.h. neben dem Aktivtresor 23, angeordnet.

Die Figur 3 zeigt den erfindungsgemäßen Sicherheitsschrank, den Aktivtresor 23, für die zu schützenden aktiven elektrischen und/oder elektronischen Komponenten, die IT Komponenten 38, mit den zugehörigen Baugruppen in der Draufsicht, in einer schematischen Schnittdarstellung mit den in der Inertisierungseinheit 10 angeordneten Baugruppen, als Schaltungsanordnung. Diese erfindungsgemäße Inertisierungseinheit 10 dient der erfindungsgemäßen, sabotagesicheren Vollinertisierung des Tresorinneren des erfindungsgemäßen Sicherheitsschrankes, d.h. des Aktivtresors 23.

Zur automatischen Dauerinertisierung des Aktivtresors 23 ist dabei außerhalb des Aktivtresors, in einem Gasspeicherschutzgehäuse 47 ein Löschgasspeicher 1 (gefüllt z.B. mit Stickstoff) mit einer Gasspeichersteuerung 46 angeordnet. In der Gasspeichersteuerung 46 ist in der Löschgasleitung 3 zur Inertisierungseinheit 10 hin zuerst, ein mit einem Endschalter zur Öffnungsüberwachung versehenes Handventil 2, nachfolgend ein Druckminderer 4, und nach diesem ein durch die Steuerung 24 zu öffnendes Speicherauslassmagnetventil 5 angeordnet. Die nachfolgend aus der Gasspeichersteuerung 46 austretende Löschgasleitung führt zur Inertisierungseinheit 10.

Aus dem Löschgasspeicher 1 (gefüllt z.B. mit Stickstoff) wird auf Anforderung der Steuerung 24 Löschgas über die Gasspeichersteuerung 46, bei durch die Steuerung 24 geöffnetem Speicherauslassmagnetventil 5 in die Inertisierungseinheit 10, dort über das Rückschlagventil 7 und dann über ein weiteres, durch die Steuerung 24 geöffnetes Gaseinlassmagnetventil 8 aus Löschgaseinlass 9 der Inertisierungseinheit 10 in den zu inertisierenden Innenraum 31 des Aktivtresors 23 geleitet.

Voraussetzung hierfür ist, dass die Tresortür 22 durch die Verschlussvorrichtung 21 verriegelt, d.h. in die geschlossen (Stellung A) gebracht wurde. Dies wird mittels des Schließsensors 18 erkannt und an die Steuerung 24 gemeldet.

Eine weitere Voraussetzung ist in diesem Zusammenhang der luftdichte Verschluß der Tresortür 22 mittels der Verschlussvorrichtung 21 und den mit dieser Zusammenwirkenden Verriegelungsbolzen 20. Dies wird durch die Verschlusssensoren 19 erfasst und ebenfalls an die Steuerung 24 gemeldet. Nach dem Verschluss der Tresortür 22 (Stellung A) kann die Inertisierung des Innenraumes 31 mittels Betätigung des Inertisierungsstarttasters 32 beginnen. Sollte die Inertisierung des Innenraumes 31 vergessen werden, wird, falls nicht zuvor ein Erinnerungssignal 34 quittiert wird, der Innenraum 31 nach einer, in der Steuerung 24 einstellbaren Verzögerung inertisiert.

Selbstverständlich ermöglicht die Steuerung auch ein mehrfaches Öffnen und Verschließen des Aktivtresors 23, z.B. während Wartungsarbeiten, ohne dass zwischendurch eine unnötige Inertisierung stattfinden müsste.

Sollte die Tresortür 22 zwar geschlossen (Meldung durch Schließsensor 18), aber nicht verschlossen (Meldung durch Verschlusssensoren 19) sein, erfolgt keine Inertsierung, sondern eine zeitgesteuerte Störungsmeldung durch das Aufleuchten eines Störungssignals 33.

Damit während des Inertisierungsvorgangs die sauerstoffhaltige Luft aus dem Innenraum 31 entweichen kann und kein ungewollter Druckanstieg erfolgt, wird diese über einen, gegenüber dem Lufteinlass 9 angeordneten Luftauslass 11, durch das von der Steuerung 24 geöffnete Gasauslassmagnetventil 12 und das Rückschlagventil 13 über den Strömungswächter 30 aus dem Innenraum 31 in die Außenatmosphäre 14 geleitet.

Dieser Vorgang dauert so lange, bis eine voreingestellte Inertisierungsqualität (beispielsweise ein Luftsauerstoffgehalt kleiner 10%) erreicht ist, wodurch eine Brandentstehung mit Luftsauerstoff im Tresorinneren 31 unter Betriebsbedingungen ausgeschlossen ist.

Die Inertisierungsqualität wird durch den Sauerstoffsensor 29, der im Bereich des Luftauslasses 11 platziert ist, erfasst und an die Steuerung 24 gemeldet.

Ist die vorgewählte Inertisierungsqualität erreicht, steuert die Steuerung 24 das Speicherauslassmagnetventil 5, das Gaseinlassmagnetventil 8 und das Gasauslassmagnetventil 12 stromlos, wodurch das Speicherauslassmagnetventil 5, das Gaseinlassmagnetventil 8 wie auch das Gasauslassmagnetventil 12 schließen.

Ab diesem Zeitpunkt ist die Innenatmosphäre im Innenraum 31 des Aktivtresors 23 dauerinertisiert und hermetisch von der Außenatmosphäre 14 getrennt.

Eine zusätzliche Sicherheitseinrichtung, besteht aus einem Überdruckauslass 15 mit einem Überdruckventil 16 der ab einem einstellbaren Überdruck zwangsläufig öffnet. Dem Überdruckventil 16 ist das Rückschlagventil 13 nachgeschaltet.

Diese Anordnung verhindert bei einem möglichen Versagen der Steuerung 24 einen gefährlichen Druckanstieg im Inneren des Aktivtresors 23. Das Ansprechen des durch die Steuerung 24 überwachten Überdruckventils 16 führt zu einer Störungsmeldung, d.h. das Störungssignal 33 leuchtet auf.

Im äußeren Brandfall wird die in den Figuren 1 bis 3 dargestellte Brandschottung 6 wirksam, durch die bei Hitzeeinwirkung von außen auch die beiden Kältemittelleitungen, der Kältemittelvorlauf 36 und der Kältemittelrücklauf 37. wie auch die die beiden Löschgasleitungen 3 gas- und rauchdicht dauerhaft verschlossen werden, so dass die Inertisierung im Innenraum 31 aufrecht erhalten bleibt.

Diese Brandschottung 6 sorgt auch für eine gasdichte, feuer- und einbruchsichere Durchführung aller Verkabelungen 35 in den Innenraum 31 des Aktivtresors 23.

Der gasdichte Verschluß der Kältemittel- und Löschgasleitungen wird durch sich verschließende Rohrstutzen 26 erreicht, an die jeweils die Kältemittel- bzw. (Löschgaszu- und Löschgasab-) Leitungen 3 an nicht brennbaren Metallmuffen 25 angeschlossen sind.

Eine Sabotage durch eine Gas-Sprengung wird durch den hermetischen Verschluss des Aktivtresors 23 verhindert. Dies wird dadurch erreicht, dass das Gaseinlassmagnetventil 8 und das Gasauslassmagnetventil 12 stromlos geschlossen sind, und auch das Rückschlagventil 13 einen "Zugang" verhindert. Der Aktivtresor 23 und seine Umgebung sind weiterhin so überwacht, das Manipulationsversuche an ihm oder in seiner Umgebung erkannt werden und eine mögliche Direktbestromung des Speicherauslassmagnetventils 5, des Gaseinlassmagnetventils 8 wie auch des Gasauslassmagnetventils 12 durch die Steuerung 24 und das mit ihr verbundene elektronischen Sabotageschutzmodul 17 unterbunden werden kann.

Dies wird dadurch erreicht, dass erfindungsgemäß alle Magnetventile, d.h. das Speicherauslassmagnetventil 5, das Gaseinlassmagnetventil 8 wie auch das Gasauslassmagnetventil 12 über das Sabotageschutzmodul 17 angesteuert werden und von außen nicht direkt bestromt werden können.

Das Sabotageschutzmodul 17 wird über manipulationssichere elektrische Leitungen / Verkabelung 35 von der Steuerung 24 angesteuert, so dass auch ein direktes Ansteuern der Magnetventile, z.B. in Verbindung mit äußeren Sabotagehandlungen, wie einem beabsichtigten Einleiten von Sprenggas erkannt und unterbunden werden kann.

Als weitere Sicherheitsmaßnahme dient die Überwachung einer maximal möglichen Befüllzeit mit Löschgas bis zur vollständigen Inertisierung des Innenraumes 31, welche durch den Strömungswächter 30 als solche sicher erkannt wird.

Bei einem eventuellen Versagen der Steuerung 24 ist so eine unabhängige Stromlosschaltung des Speicherauslassmagnetventils 5 und des Gaseinlassmagnetventils 8 sowie eine externe Gefahrensignalisierung durch Aufleuchten des Störungssignals 33 gewährleistet.

Durch die erfindungsgemäße mehrfache Überwachung der Dauerinertisierung des Innenraumes 31 ist eine, für Menschen gefährliche, ungewollte Inertisierung der Aktivtresor-Umgebung durch technisches Versagen weitestgehend unmöglich, wie auch ein ungewollter Betrieb ohne Inertisierung ausgeschlossen.

Alle pneumatischen Bauelemente befinden sich aus Gründen einer kostengünstigen Fertigung und Instandhaltung in einer leicht austauschbaren Innertisierungseinheit 10.

Bei einer Öffnung (Stellung B) der Tresortür 22 mittels der Verschlussvorrichtung 21 (z.B. für Wartungsarbeiten) wird die Inertisierung des Tresor-Inneren 31 durch Entweichen des Inertgases aufgehoben.

Die Steuerung 24 erkennt diesen Zustand und hält das Speicherauslassmagnetventil 5 und das Gaseinlassmagnetventil 8 bis zum erneuten Verschluß des Aktivtresors 23 geschlossen.

Danach kann der beschriebene Vorgang der Inertisierung erneut beginnen.

Eine Inertisierung des geöffneten Aktivtresors 23 ist nicht notwendig.

Die Anordnung des Löschgasspeichers 1 außerhalb des Aktivtresors hat neben den Vorteilen der Platzersparnis und der Brand-, Einbruch- und Sabotgesicherheit noch den erheblichen Vorteil, dass die Füllung des Löschgasbehälters 1 nicht dauernd überwacht werden muss, so wie dies beim Not-Inertisierungsprinzip vorgeschrieben ist bzw. gefordert wird.

Das ist dadurch möglich, da erfindungsgemäß eine nicht ausreichende Inertisierung auch zeitüberwacht ist, und eine nicht ausreichende Füllung des Löschgasbehälters 1 in diesem Zusammenhang signalisiert wird, so dass ein eventueller Löschgasmangel spätestens dann behoben werden kann.

Dadurch kann eine aufwändige Überwachung des Löschgasvorrates vermieden werden.

Durch Entfall einer aufwändigen Überwachung des Löschmittelvorrates ist ein einfacher und preisgünstiger Aufbau der erfindungsgemäßen Einrichtung möglich. Mittels der erfindungsgemäßen Lösung ist es gelungen einen Sicherheitsschrank für aktive elektrische und elektronische Komponenten zu entwickeln der die beschriebenen Nachteile beseitigt, einen instandhaltungsarmen, zuverlässigen Dauerbetrieb bei höchster Einbruchs- und Sabotagesicherheit und einen höchstmöglichen äußeren und inneren Brandschutz, mit minimalem zusätzlichen Bauraum für die Brandschutzkomponenten, gewährleistet und der zudem im Extremfall, d.h. selbst nach dem Kappen aller Verbindungsleitungen zur "Außenwelt" selbst unter einer Brandlast von 1200 °C über 2h die Sicherheit / Unversehrtheit der zu schützenden aktiven IT-Komponenten 38 gewährleistet.

### Bezugszeichenzusammenstellung

- 1: Löschgasspeicher
- 2: Handventil (mit Endschalter zur Öffnungsüberwachung)
- 3: Löschgasleitung
- 4: Druckminderer
- 5: Speicherauslassmagnetventil
- 6: Brandschottung
- 7: Rückschlagentil
- 8: Gaseinslassmagnetventil
- 9: Löschgaseinlass
- 10: Inertisierungseinheit
- 11: Luftauslass
- 12: Gasauslassmagnetventil
- 13: Rückschlagventil
- 14: Außenatmosphäre
- 15: Überdruckauslass
- 16: Überdruckventil
- 17: Sabotageschutzmodul (elektronisch)
- 18: Schließsensor
- 19: Verschlusssensor
- 20: Verriegelungsbolzen
- 21: Verschlussvorrichtung
- 22: Tresortür
- 23: Aktivtresor
- 24: Steuerung
- 25: Metallmuffe
- 26: Rohrstutzen
- 27: Befeuchtungseinrichtung
- 28: Luftfeuchtesensor
- 29: Sauerstoffsensor
- 30: Strömungswächter
- 31: Innenraum
- 32: Inertisierungsstarttaster
- 33: Störungssignal
- 34: Erinnerungssignal
- 35: Verkabelung
- 36: Kältemittelvorlauf
- 37: Kältemittelrücklauf
- 38: IT-Komponente
- 39: Wärmetauscher
- 40: Kältemaschine
- 41: Notstromversorgung
- 42: Latentkältespeicher
- 43: Brandfrühsterkennungssensor
- 44: Riegeltasche
- 45: Tresortürscharnier
- 46: Gasspeichersteuerung
- 47: Gasspeicherschutzgehäuse

## Patentansprüche

1. Sicherheitsschrank für aktive elektrische und/oder elektronische Anlagen wobei,
- es sich bei diesem Sicherheitsschrank um einen Aktivtresor (23), mit einer ein Tresorinneres mittels einer Verschlussvorrichtung (21) luftdicht verschließenden Tresortür (22) handelt, und
- im Tresorinneren des Aktivtresors (23) in einem Innenraum (31) aktive elektrische und elektronischen Komponenten, wie IT-Komponenten (38) angeordnet sind an denen wiederum Verkabelungen (35) angeordnet sind die durch in der Tresorwand angeordnete, luftdichte Brandschottungen (6) hindurch aus dem Tresorinneren nach außen geführt sind, und
- im Tresorinneren des Aktivtresors (23) neben dem Innenraum (31) ein Wärmetauscher (39) angeordnet ist, der mit einer außerhalb des Aktivtresors (23) angeordneten Kältemaschine (40) über Rohrleitungen, einen Kältemittelvorlauf (36) und einen Kältemittelrücklauf (37) verbunden ist, wobei auch diese Rohreitungen durch in der Tresorwand angeordnete, luftdichte Brandschottungen (6) hindurch aus dem Innenraum (31) nach außen geführt sind und
- im Tresorinneren des Aktivtresors (23) zudem ein Latentkältespeicher (42) angeordnet ist, und
- im Tresorinneren des Aktivtresors (23) weiterhin eine Notstromversorgung (41) angeordnet ist, und
- im Tresorinneren des Aktivtresors (23) ein/mehrere Brandfrühsterkennungssensor/en (43) angeordnet ist/sind, und
- im Tresorinneren eine Inertisierungseinheit (10) angeordnet ist, an der Löschgasleitungen (3) angeordnet sind, die durch in der Tresorwand angeordnete, luftdichte Brandschottungen (6) hindurch aus dem Tresorinneren nach außen geführt sind, wobei eine der Löschgasleitungen (3) der Löschgaszuleitung und die andere der Löschgasleitungen (3) der Ableitung der Luft bzw. des Löschgasluftgemisches aus dem Innenraum (31) in die Außenatmosphäre (14) dient, und
- die Inertisierungseinheit (10) im Dauerbetrieb über eine der Löschgasleitungen (3), der Löschgaszuleitung, mit einem außerhalb des Aktivtresors (23) angeordneten Löschgasspeicher (1) in Verbindung steht, und
- an der Inertisierungseinheit (10) ein in den Innenraum (31) mündender Löschgaseinlass (9), sowie diesem Löschgaseinlass (9) an der Inertisierungseinheit (10) gegenüberliegend, ein den Austritt der Gase aus dem luftdicht verschlossenen dem Tresorinneren ermöglichender Luftauslass (11) mit einem diesem benachbart angeordneter, mit einem Überdruckventil (16) versehener, Überdruckauslass (15) angeordnet ist, welcher ab einem einstellbaren Überdruck zwangsläufig öffnet, und
- im Bereich des Luftauslasses (11) im Tresorinneren ein Sauerstoffsensor (29) angeordnet ist,
- im Tresorinneren zudem ein Luftfeuchtesensor (28) mit einer von diesem gesteuerten Befeuchtungseinrichtung (27) angeordnet ist.
- im Innern der Inertisierungseinheit (10) ein elektronisches Sabotageschutzmodul (17) angeordnet ist, welches mittels elektrischer Leitungen / Verkabelungen (35) sowohl mit dem Gaseinlassmagnetventil (8), wie auch mit dem Gasauslassmagnetventil (12) und der Steuerung (24) verbunden ist, so dass ein direktes Ansteuern der beiden Magnetventile, dem Gaseinlassmagnetventil (8) und dem Gasauslassmagnetventil (12), in Verbindung mit äußeren Sabotagehandlungen, wie z.B. einem beabsichtigten Einleiten von Sprenggas, erkannt und verhindert wird;
- die in der Inertisierungseinheit (10) angeordneten Bauteile über Verkabelungen (35) mit einer außerhalb des Aktivtresors (23) angeordneten Steuerung (24), einem ebenfalls außerhalb des Aktivtresors (23) angeordneten Löschgasspeicher (1), und/oder mit in dessen Löschgasleitung (3) zur Inertisierungseinheit (10) im Aktivtresor (23) angeordneten Baugruppen verbunden sind, wobei auch diese Verkabelungen (35) durch in der Tresorwand angeordnete, luftdichte Brandschottungen (6) hindurch aus dem Innenraum (31) nach außen zu den jeweiligen Baugruppen geführt sind.

2. Sicherheitsschrank für aktive elektrische und/oder elektronische Anlagen nach Anspruch 1, **dadurch gekennzeichnet,**
- **dass** an der Tresortür (22) ein mit der Steuerung (24) verbundener Schließsensor (18) angeordnet ist, der die Betätigung der Verschlussvorrichtung (21) an die Steuerung (24) meldet, und
- **dass** im Bereich der Verriegelungsbolzen (20) der Tresortür (22) zudem Verschlusssensoren (19) angeordnet sind, die den luftdichten Verschluss der Tresortür (22) an die Steuerung (24) melden, und
- **dass** an der Steuerung (24) ein Inertisierungsstarttaster (32) angeordnet ist, mit dem die Inertisierung des Innenraumes (31) mittels der Inertisierungseinheit (10) zur automatischen Dauerinertisierung des Aktivtresors (23) eingeleitet werden kann, und
- **dass** am Löschgasspeicher (1) (gefüllt z.B. mit Stickstoff) eine Gasspeichersteuerung (46) angeordnet ist in deren Löschgasleitung (3) zur Inertisierungseinheit (10) hin, zuerst ein mit einem Endschalter zur Öffnungsüberwachung versehenes Handventil (2), nachfolgend ein Druckminderer (4), und nach diesem ein, durch die Steuerung (24) zu öffnendes Speicherauslassmagnetventil (5) angeordnet ist, und
- **dass** diese Löschgasleitung (3) in der Inertisierungseinheit (10) über ein Rückschlagventil (7) und ein, durch die Steuerung (24) zu öffnendes Gaseinlassmagnetventil (8) zum Löschgaseinlass (9) führt, über den das Löschgas in den zu inertisierenden Innenraum (31) des Aktivtresors (23) eingeleitet wird, und
- **dass** in/an der Inertisierungseinheit (10) dem Löschgaseinlass (9) gegenüberliegend ein Luftauslass (11) mit einer Verbindungsleitung nach außen, zur Außenatmosphäre (14) angeordnet ist, wobei in dieser Verbindungsleitung neben dem Luftauslass (11) ein von der Steuerung (24) zu betätigendes Gasauslassmagnetventil (12), diesem benachbart ein Rückschlagventil (13) und diesem in Richtung zur Außenatmosphäre (14) hin benachbart ein Strömungswächter (30) angeordnet sind, um die sauerstoffhaltige Luft aus dem Innenraum (31) in die Außenatmosphäre (14) zu leiten, und
- **dass** im Bereich des Luftauslasses (11) ein Sauerstoffsensor (29) angeordnet ist, der den Sauerstoffgehalt, d.h. die Inertisierungsqualität, erfasst und das Erreichen eines voreingestellten Wertes der Inertisierungsqualität an die Steuerung (24) meldet, und
- **dass** die Steuerung (24) nach dem Erreichen der vorgewählten Inertisierungsqualität das Speicherauslassmagnetventil (5), das Gaseinlassmagnetventil (8) und das Gasauslassmagnetventil (12) stromlos schaltet und dadurch schließt, so dass der von der Außenatmosphäre (14) hermetisch getrennte Innenraum (31) damit dauerinertisiert ist.

3. Sicherheitsschrank für aktive elektrische und/oder elektronische Anlagen nach Anspruch 1 und/oder 2, **dadurch gekennzeichnet,**
- **dass** mit einer Steuerung (24) mehrere Aktivtresore (23) gleichzeitig verwaltet werden, wie auch mit einem Gasspeicher (1) mehrere Aktivtresore (23) inertisiert, und mit nur einer Kältemaschine (40) die Wärmetauscher (39) auch von mehreren Aktivtresoren (23) betrieben werden.

4. Sicherheitsschrank für aktive elektrische und/oder elektronische Anlagen nach einem oder mehreren der Ansprüche 1 bis 3, **dadurch gekennzeichnet,**
- **dass** das Überdruckventil (16) von der Steuerung (24) so überwacht wird, dass das Ansprechen des Überdruckventils (16) zu einer Störungsmeldung durch das Aufleuchten eines Störungssignals (33) führt.

## Claims

1. Safe for active electrical and/or electronic components, wherein,
- with this safe we are dealing with an Active safe (23), with a Safe door (22) which seals the insides of the safe airtight by means of a Closer (21), and
- active electrical and electronic components such as IT components (38) arranged inside the Active safe (23) in an Inner chamber (31), on which in turn Cabling (35) is arranged, which is led outwards from inside the safe through air-tight Fire walls (6) to the outside, and
- a Heat exchanger (39) is arranged inside the Active safe (23) alongside the Inner chamber (31), which is connected to a Cooling device (40) arranged outside of the Active safe (23), via pipes, a Cooling agent flow direction (36) and Cooling agent reflow (37), wherein these pipes are also led out of the Inner chamber (31) towards the outsides through air-tight Fire walls (6) and
- in addition a Latent-cold storage unit (42) is arranged inside the Active safe (23), and
- an Emergency power supply (41) is also arranged inside the Active safe (23), and
- one or more Early fire detection sensor(s) (43) is/are also arranged inside the Active safe (23), and
- an Inertising unit (10) is arranged inside the safe, to which Gaseous extinguishing agent pipes (3) are attached, which are led from inside the safe to the outside through air-tight Fire walls (6) arranged in the safe wall, wherein one of the Gaseous extinguishing agent pipes (3) serves as the gaseous extinguishing agent supply pipe, and the other one of the Gaseous extinguishing agent pipes (3) serves as the gaseous extinguishing agent discharge pipe for discharging the air or the gaseous extinguishing agent mixture from the Inner chamber (31) to the External atmosphere (14), and
- in non-stop operation the Inertising unit (10) is connected via one of the Gaseous extinguishing agent pipes (3), the gaseous extinguishing agent supply pipe to a Gaseous extinguishing agent store (1) arranged outside of the Active safe (23), and
- on the Inertising unit (10) an Extinguishing agent gas inlet (9) leading into into the Inner chamber (31), as well as well as an Air outlet (11) positioned across from this Extinguishing agent gas inlet (9) on the Inertising unit (10), making the outlet of gases from the air-tight sealed insides of the safe possible, which is arranged with a Pressure outlet (15) fitted with an Overpressure valve (16), which inevitably opens from an adjustable value of overpressure, and
- in which an Oxygen sensor (29) is arranged in the region of the Air outlet (11) inside the safe, and
- in addition an Air humidity sensor (28) is arranged inside the safe, with a Humidifier device (27) governed by this, and
- an electronic Sabotage protection module (17) is arranged inside the Inertising unit (10), which is connected to both the Gas inlet magnetic valve (8), as well as also to the Gas outlet magnetic valve (12) and Controls (24) by means of electric leads/Cabling (35), so that direct control of both magnetic valves, of the Gas inlet magnetic valve (8) and the Gas outlet magnetic valve (12), will be detected and prevented in conjunction with external sabotage actions, such as intentionally introducing explosive gas, for example, and
- the components arranged in the Inertising unit (10) are connected with Controls (24) arranged outside of the Active safe (23) via Cabling (35), with a Gaseous extinguishing agent store (1) likewise arranged outside of the Active safe (23), and/or with assemblies arranged in its Gaseous extinguishing agent pipe (3) to the Inertising unit (10) in the Active safe (23), wherein this Cabling (35) is also led through air tight Fire walls (6) arranged in the safe wall, out of the Inner chamber (31) to the outside of the respective assembly.

2. Safe for active electrical and/or electronic components according to Claim 1, **characterized in,**
- **that** a Locking sensor (18) connected to the Controls (24) is arranged on the Safe door (22), which notifies the Controls (24) of activation of the Closer (21), and
- **that** in addition, Closer sensors (19) are arranged in the region of the Locking bolts (20) of the Safe door (22), which notify the Controls (24) of air-tight closing of the Safe door (22), and
- **that** a Start inertisation button (32) is arranged on the Controls (24), with which inertisation of the Inner chamber (31) can be initiated by means of the Inertising unit (10), for automatic non-stop inertisation of the Active safe (23), and
- **that** a Gas store control (46) is arranged on the Gaseous extinguishing agent store (1) (filled for example with nitrogen), in the Gaseous extinguishing agent pipe (3) towards the Inertising unit (10) of which, firstly a Hand valve (2) fitted with a limiting switch to monitor opening is fitted, after this a Pressure reducer (4), and following this a Store outlet magnetic valve (5) is arranged which can be opened by the Controls (24), and
- **that** this Gaseous extinguishing agent pipe (3) in the Inertising unit (10) leads to the Extinguishing agent gas inlet (9) via a Non-return valve (7) and a Gas inlet magnetic valve (8), which can be opened by the Controls (24), through which gaseous extinguishing agent is introduced to the Inner chamber (31) of the Active safe (23), and
- **that** in/on the Inertising unit (10), an Air outlet (11) is arranged across from the Extinguishing agent gas inlet (9), with a connecting pipe towards the outside, to the External atmosphere (14), wherein a Gas outlet magnetic valve (12) activated by the Controls (24) is arranged in the connecting pipe alongside the Air outlet (11), and adjacent to this a Non-return valve (13), and a Flow monitor (30) is arranged alongside this, in the direction of the External atmosphere (14) in order to lead air containing oxygen from the Inner chamber (31) to External atmosphere (14), and
- **that** an Oxygen sensor (29) is arranged in the region of the Air outlet (11), which records the oxygen content i.e. the quality of inertisation, and notifies the Controls (24) when a pre-set value of inertisation quality being reached, and
- **that** after reaching the pre-set inertisation quality, the Controls (24) switch off the Store outlet magnetic valve (5), the Gas inlet magnetic valve (8) and the Gas outlet magnetic valve (12), and in this way it closes, so that in this way the Inner chamber (31) hermetically sealed off from the External atmosphere (14) is permanently inertised.

3. Safe for active electrical and/or electronic components according to Claim 1 and/or Claim 2, **characterized in,**
- **that** several Active safes (23) are administered at the same time by one Control (24), just as several Active safes (23) can be inertised with one Gaseous extinguishing agent store (1), and that the Heat exchangers (39) of several Active safes (23) can also be operated by only one Cooling device (40).

4. Safe for active electrical and/or electronic components according to one or more of the Claims 1 to 3, **characterized in,**
- **that** the Overpressure valve (16) is monitored by Controls (24) in such a way, that activation of the Overpressure valve (16) causes an error message by an Error message signal (33) lighting up.

## Revendications

1. Armoire de sécurité pour composants électriques et/ou électroniques actifs,
- laquelle armoire de sécurité constitue un coffre-fort actif (23) équipé d'une porte de coffre-fort (22) pourvue d'un dispositif de verrouillage (21) fermant hermétiquement un intérieur de coffre-fort, et
- des composants électriques et électroniques actifs, comme des composants IT (38), étant disposés à l'intérieur du coffre-fort actif (23) dans un espace intérieur (31), sur lesquels sont en outre placés des câblages (35) passés vers l'extérieur hors de l'intérieur de coffre-fort au travers de cloisons coupe-feu (6) hermétiques disposées dans la paroi du coffre-fort, et
- un échangeur thermique (39) étant disposé à l'intérieur du coffre-fort actif (23) à côté de l'espace intérieur (31), lequel échangeur étant relié à une machine frigorifique (40) située à hors du coffre-fort actif (23) par le biais de conduites, d'un écoulement de liquide réfrigérant (36) et d'un retour de liquide réfrigérant (37), ces conduites étant également passées vers l'extérieur hors de l'espace intérieur (31) au travers de cloisons coupe-feu (6) hermétiques disposées dans la paroi du coffre-fort, et
- un accumulateur de froid latent (42) étant en outre disposé à l'intérieur du coffre-fort actif (23), et
- une alimentation de secours (41) étant de plus disposée à l'intérieur du coffre-fort actif (23), et
- un/plusieurs capteur/s de détection précoce d'incendie (43) étant disposé/s à l'intérieur du coffre-fort actif (23), et
- une unité d'inertage (10) étant disposée à l'intérieur du coffre-fort, sur laquelle des conduites de gaz d'extinction (3) sont placées, ces conduites étant dirigées vers l'extérieur hors de l'intérieur de coffre-fort au travers de cloisons coupe-feu (6) hermétiques disposées dans la paroi du coffre-fort, l'une des conduites de gaz d'extinction (3) servant d'admission de gaz d'extinction tandis que l'autre de ces conduites de gaz d'extinction (3) servant à la dérivation de l'air voire du mélange air-gaz d'extinction hors de l'espace intérieur (31) vers l'atmosphère extérieure (14), et
- l'unité d'inertage (10) étant en connexion en fonctionnement permanent avec un accumulateur de gaz d'extinction (1) disposé hors du coffre-fort actif (23) par le biais d'une des conduites de gaz d'extinction (3), l'admission de gaz d'extinction, et
- sur l'unité d'inertage (10), une entrée de gaz d'extinction (9) étant disposée, débouchant dans l'espace intérieur (31), ainsi qu'en face de cette entrée de gaz d'extinction (9) sur l'unité d'inertage (10), une évacuation d'air (11) permettant la sortie des gaz hors de l'intérieur du coffre-fort fermé hermétiquement, avec une évacuation de surpression (15) disposée au voisinage de l'évacuation d'air (11) équipée d'une soupape de surpression (16), laquelle évacuation de surpression (15) s'ouvre inévitablement à partir d'une surpression réglée, et
- un capteur d'oxygène (29) étant disposé à l'intérieur du coffre-fort dans la zone d'évacuation d'air (11), et
- un capteur d'humidité de l'air (28) étant en outre disposé à l'intérieur du coffre-fort avec un dispositif d'humidification (27) piloté par celui-ci, et
- un module de protection anti-sabotage (17) électronique étant disposé à l'intérieur de l'unité d'inertage (10), lequel est relié au moyen de lignes / câblages (35) électriques aussi bien avec l'électrovanne d'admission de gaz (8) qu'avec l'électrovanne de sortie de gaz (12) et la commande (24), de sorte qu'un pilotage direct des deux électrovannes, l'électrovanne d'admission de gaz (8) et l'électrovanne de sortie de gaz (12), en association avec des activités extérieures de sabotage, comme par exemple l'introduction volontaire de gaz explosif, est reconnu et évité, et
- les composants disposés dans l'unité d'inertage (10) étant reliés par câblages (35) à une commande (24) placée hors du coffre-fort actif (23), à un accumulateur de gaz d'extinction (1) placé également hors du coffre-fort actif (23) et/ou à de modules placés dans sa conduite de gaz d'extinction (3) vers l'unité d'inertage (10) dans le coffre-fort actif (23), ces câblages (35) étant aussi passées vers l'extérieur en direction des modules respectifs hors de l'espace intérieur (31) au travers de cloisons coupe-feu (6) hermétiques disposées dans la paroi du coffre-fort.

2. Armoire de sécurité pour composants électriques et/ou électroniques actifs selon l'exigence 1 **caractérisée par le fait**
- **qu'**un capteur de fermeture (18) raccordé à la commande (24) est disposé sur la porte de coffre-fort (22), signalant l'actionnement du dispositif de verrouillage (21) à la commande (24), et
- **que**, dans la zone des boulons de verrouillage (20) de porte de coffre-fort (22), des capteurs de verrouillage (19) sont en outre disposés, ceux-ci signalant le verrouillage hermétique de la porte de coffre-fort (22) à la commande (24), et
- **que**, sur la commande (24), une touche de démarrage d'inertage (32) est disposée, avec laquelle l'inertage de l'espace intérieur (31) peut être lancé au moyen de l'unité d'inertage (10) en vue de l'inertage permanent du coffre-fort actif (23), et
- **que**, sur l'accumulateur de gaz d'extinction (1) (rempli p. ex. d'azote), une commande d'accumulateur de gaz (46) est disposée et, dans la conduite de gaz d'extinction (3) de celle-ci vers l'unité d'inertage (10), est disposée en premier une soupape manuelle (2) équipée d'un interrupteur de fin de course destiné à la surveillance d'ouverture, suivie d'un réducteur de pression (4), et après celui-ci une électrovanne de sortie d'accumulateur (5) à ouvrir par la commande (24), et
- **que** cette conduite de gaz d'extinction (3) dans l'unité d'inertage (10) conduit à l'entrée de gaz d'extinction (9) via une soupape anti-retour (7) et une électrovanne d'admission de gaz (8) à ouvrir par la commande (24), le gaz d'extinction étant conduit via l'entrée de gaz d'extinction (9) dans l'espace intérieur (31) de coffre-fort actif (23) devant être rendu inerte, et
- **que** dans/sur l'unité d'inertage (10), en face de l'entrée de gaz d'extinction (9), une évacuation d'air (11) est disposée vers l'extérieur, vers l'atmosphère extérieure (14) via une conduite de raccordement, une électrovanne de sortie de gaz (12) à actionner par la commande (24) est disposée dans cette conduite de raccordement à côté de l'évacuation d'air (11), une soupape anti-retour (13) étant disposée au voisinage de l'électrovanne de sortie de gaz (12) et un contrôleur de débit (30) étant placé au voisinage de la soupape anti-retour (13) en direction de l'atmosphère extérieure (14), afin de diriger l'air chargé d'oxygène hors de l'espace intérieur (31) vers l'atmosphère extérieure (14), et
- **que**, dans la zone d'évacuation d'air (11), un capteur d'oxygène (29) est disposé, saisissant la teneur en oxygène, c'est-à-dire la qualité d'inertage, et signalant à la commande (24) qu'une valeur pré-réglée de qualité d'inertage a été atteinte, et
- **que** la commande (24), après que la qualité d'intertage présélectionnée ait été atteinte, met hors tension l'électrovanne de sortie d'accumulateur (5), l'électrovanne d'admission de gaz (8) et l'électrovanne de sortie de gaz (12) et ferme ainsi de sorte que l'espace intérieur (31) hermétiquement séparé de l'atmosphère extérieure (14) soit ainsi rendu inerte en permanence.

3. Armoire de sécurité pour composants électriques et/ou électroniques actifs selon l'exigence 1 et/ou 2 **caractérisée par le fait**
- **que** plusieurs coffres-forts actifs (23) sont gérés simultanément par une commande (24), tout comme plusieurs coffres-forts actifs (23) sont rendus inertes avec un accumulateur de gaz (1), et que les échangeurs thermiques (39) sont aussi exploités par plusieurs coffres-forts actifs (23) avec une seule machine frigorifique (40).

4. Armoire de sécurité pour composants électriques et/ou électroniques actifs selon une ou plusieurs des exigences 1 à 3 **caractérisée par le fait**
- **que** la soupape de surpression (16) est surveillée par la commande (24) de sorte que l'adressage de la soupape de surpression (16) conduit à un message d'erreur indiqué par l'allumage d'un signal de dysfonctionnement (33).
